# EUROPÄISCHE PATENTSCHRIFT

(11) **EP 3 590 130 B1**
(45) Veröffentlichungstag und Bekanntmachung des Hinweises auf die Patenterteilung: **22.04.2026**
(21) Anmeldenummer: 17710159.9
(22) Anmeldetag: 02.03.2017
(51) Int. Cl.: H01L 21/683, H01L 23/544, H01L 21/60, H01L 21/78, H01L 21/67, H01L 25/065

(54) **VERFAHREN UND VORRICHTUNG ZUM BONDEN VON CHIPS**
METHOD AND DEVICE FOR BONDING CHIPS
PROCÉDÉ ET DISPOSITIF D'ASSEMBLAGE DE PUCES

(43) Veröffentlichungstag der Anmeldung: 08.01.2020
(60) Teilanmeldung: 26154798.8
(73) Patentinhaber: EV Group E. Thallner GmbH, St. Florian am Inn (AT)
(72) Erfinder: WIMPLINGER, Markus, 4910 Ried im Innkreis (AT)
(74) Vertreter: Schneider, Sascha
(86) Internationale Anmeldenummer: PCT/EP2017/054971
(87) Internationale Veröffentlichungsnummer: WO 2018/157937

(56) Entgegenhaltungen:
- JP-B2- 4 064 808
- JP-B2- 4 064 808
- US-A1- 2003 115 747
- US-A1- 2003 115 747
- US-A1- 2013 075 868
- US-A1- 2013 075 868
- US-A1- 2015 228 535
- US-A1- 2016 190 087
- US-A1- 2016 190 087

## Beschreibung

Die Erfindung betrifft ein Verfahren und eine Vorrichtung zum Bonden von Chips.

Chip-to-Wafer- (C2W) oder Chip-to-Chip- (C2C) -Prozesse werden im Stand der Technik über Lötkugeln oder Kupfersäulen mit Lotkappen (engl. Copper pillars with solder caps) ausgeführt. Die Lötkugeln bzw. Kupfersäulen mit Lotkappen sind allerdings extrem groß und erhöhen die Dicke der so erzeugten Chips.

US 2015/0228535 A1 offenbart ein Verfahren zur Herstellung von Halbleiterstrukturen. US 2016/0190087 A1 offenbart eine Chip-Stapelvorrichtung zum Stapeln eines Chips auf einem Substrat. US 2003/0115747 A1 offenbart ein Aufnahmewerkzeug mit einem Saugorgan aus elastisch verformbarem Material. US 2013/0075868 A1 offenbart das Übertragen einer Schicht aus Halbleitermaterial von einer ersten Donatorstruktur auf eine zweite Struktur. JP4064808B offenbart eine Flüssigkristallzelle, die auf einem Montagepad angebracht ist.

Es ist daher die Aufgabe der vorliegenden Erfindung, ein verbessertes Bondverfahren bzw. eine verbesserte Bondvorrichtung anzugeben.

Diese Aufgabe wird mit dem Gegenstand der nebengeordneten Patentansprüche gelöst.

Erfindungsgemäß vorgesehen ist ein Verfahren zum Bonden eines Chips auf ein Halbleitersubstrat oder auf einen weiteren Chip, wobei der Chip durch einen Direktbond auf das Halbleitersubstrat oder den weiteren Chip gebondet wird. Unter einem Direktbond versteht man einen Bond, der sich direkt über die Wechselwirkung zweier Oberflächen ausbildet, ohne eine Flüssigphase zu bilden. Gemäß einer anderen Begriffsdefinition versteht man unter einem Direktbond einen Bond, bei dem man keine Zusatzmaterialien verwenden muss. Insbesondere versteht man unter einem Direktbond einen Metall-Metall Festkörperbond, insbesondere Diffusionsbond, einen Prebond bzw. einen aus dem Prebond hervorgehenden Fusionsbond oder einen Hybridbond, d.h. einen Bond der auf Fusionsbondanteilen und Metallbondanteilen beruht.

Weiterhin erfindungsgemäß vorgesehen ist eine Vorrichtung zum Bonden eines Chips auf ein Halbleitersubstrat oder einen weiteren Chip, wobei der Chip durch einen Direktbond auf das Halbleitersubstrat oder den weiteren Chip gebondet werden können.

Weiterhin wird offenbart ein Chipstapel aus Chips, wobei die Chips durch einen Direktbond miteinander gebondet sind.

Weiterhin offenbart wird ein Substrat mit Chips (Produkt), wobei die Chips durch einen Direktbond auf das Substrat gebondet sind.

Es wird erfindungsgemäß eine Direktbondmöglichkeit auf C2C- oder C2W-Ebene ermöglicht. Man benötigt vorteilhaft keine Lötkugeln oder Kupfersäulen mit Lotkappen mehr. Die Dicken der erzeugten Chipstapel bzw. Produkte werden geringer, der Durchsatz wird erhöht und die Leistungsfähigkeit der Chipkommunikation steigt. Das Direktbonden weist insbesondere eine Bondstärke von mehr als 0.1 J/m2, vorzugsweise mehr als 0.5 J/m2, noch bevorzugter mehr als 1.0 J/m2, am bevorzugtesten mehr als 2.0 J/m2, am allerbevorzugtesten mehr als 2.5 J/m2 auf. Das Direktbonden erfolgt insbesondere bei Temperaturen von weniger als 400°C, vorzugsweise weniger als 300°C, noch bevorzugter bei weniger als 2000°C, am bevorzugtesten weniger als 150°C, am allerbevorzugtesten weniger als 100°C. Des Weiteren findet das Direktbonden ohne die Erzeugung einer flüssigen Phase statt.

Offenbart wird, die Oberfläche eines Chips so sauber zu halten, dass ein folgender Direktbondschritt erfolgen kann. Die so präparierten Chips mit kontaminationsfreier Bondoberfläche können dann auf das Substrat (engl.: chip-to-wafer, C2W) oder auf andere Chips (engl.: chip-to-chip, C2W) gebondet werden.

Unter einem Substrat bzw. Halbleitersubstrat wird im weiteren Verlauf der Druckschrift ein noch nicht vereinzeltes, insbesondere rundes, Halbzeug der Halbleiterindustrie verstanden. Mit besonderem Vorzug handelt es sich bei einem Substrat um einen Wafer. Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben.

Unter einem Chip wird im weiteren Verlauf der Druckschrift ein durch Vereinzeln eines Halbleitersubstrats (Wafer) gewonnenes, zumeist rechteckiges, Teil verstanden. Ein Chip enthält üblicherweise eine integrierte Schaltung, die bei der Bearbeitung des Halbleitersubstrats entsteht.

Unter einer Bondoberfläche wird in der Druckschrift eine Oberfläche verstanden, die im Zuge eines Prozesses irgendwann einmal Teil einer Bondgrenzfläche wird. Im Speziellen versteht man unter der Bondoberfläche die Oberfläche eines Chips, die erfindungsgemäß behandelt, insbesondere gereinigt, werden muss, bevor der Chip gebondet wird. Wird ein Chip auf ein Substrat gebondet, kann die Substratoberfläche ebenfalls als Bondoberfläche bezeichnet werden.

Erfindungsgemäß handelt es sich bei den Bondoberflächen um Hybridbondoberflächen. Unter einer Hybridbondoberfläche versteht man eine Bondoberfläche, die aus metallischen und dielektrischen Bereichen und damit aus metallischen und dielektrischen Bondoberflächenteilen besteht. Alle in der Druckschrift genannten Verfahren und/oder Vorrichtungen, die sich auf das Direktbonden im Allgemeinen beziehen, lassen sich daher auf das Bonden von Hybridoberflächen anwenden. Mit Vorzug befinden sich die metallischen und dielektrischen Oberflächenteile weitgehend in einer Ebene. Insbesondere sind die metallischen Oberflächenteile weniger als 0,5 µm, mit bevorzugt weniger als 100 nm, bevorzugter weniger als 50 nm, am bevorzugtesten weniger als 10 nm gegenüber den dielektrischen Oberflächenteilen zurückgesetzt oder stehen gegenüber den dielektrischen Oberflächenteilen vor.

### Reinigungsverfahren

In der weiteren Druckschrift versteht man unter einer Reinigung die Entfernung von Kontaminationen der Bondoberfläche durch eines und/oder mehrere der folgenden Verfahren:
- Nasschemische Reinigung, insbesondere
   ∘ mit Wasser, insbesondere
      ▪ CO2 haltiges Wasser
   ∘ mit Alkoholen
   o mit Säuren, insbesondere
      ▪ Ameisensäure
      ▪ Zitronensäure
      ▪ Peroxomonoschwefelsäure
      ▪ Standardelean 1 (SC1)
      ▪ Standardelean 2 (SC2)
   o Mit Basen, insbesondere
      ▪ NH4OH
- Plasmareinigung
- Plasmaveraschung
- Mechanische Reinigung, insbesondere
   o Bürsten

Unter einer Plasmareinigung versteht man den, im Allgemeinen hochenergetische, Beschuss einer Oberfläche mit den ionisierten Teilen eines Plasmas. Die Ionen des Plasmas werden dabei durch elektrische und/oder magnetische Felder beschleunigt und besitzen eine nicht zu vernachlässigende Eindringtiefe. Eine Plasmareinigung kann mit der Plasmaaktivierung einer Oberfläche einhergehen.

Unter einer Plasmaveraschung versteht man den, im Allgemeinen niederenergetischen, Reinigungsprozess organischer Substanzen von einer Oberfläche. Die Reinigung erfolgt dabei insbesondere durch Oxidation der organischen Spezies, insbesondere mit Sauerstoff und/oder Fluor oder einem beliebigen anderen, geeigneten und ionisierbaren Oxidationsmittel. Die durch die Plasmaveraschung oxidierten organischen Komponenten werden vorzugsweise aus der Reaktionskammer abgeführt. Dies erfolgt entweder durch einen kontinuierlichen Strom des Plasmas oder durch ein sequentielles Entlüften und Belüften der Plasmakammer. In einer bevorzugteren Ausführungsform werden die veraschten und oxidieren organischen Komponenten allerdings innerhalb der Plasmakammer durch chemische und/oder physikalische Verfahren gebunden, sodass Ihr Rückweg zur Substratoberfläche verhindert wird. Dadurch werden komplizierte Vorrichtungen, die eine Zirkulation des Plasmas voraussetzen, vermieden.

Optional wird nach der Plasmaveraschung eine Nasschemische Reinigung mit einer oder mehreren der oben genannten Flüssigkeiten durchgeführt, um damit die Sauberkeit der Oberfläche und / oder die Oberflächenchemie der zu reinigenden Oberflächen noch weiter zu verbessern, insbesondere durch Terminierung der Oberfläche mit geeigneten, dem Fachmann bekannten Spezies für das Bonden zu optimieren. Mit Vorteil dient das Verfahren dazu, Partikel, die insbesondere bei der Plasma Veraschung entstanden und / oder auf der Oberfläche zurückgeblieben sind, zu entfernen.

Die Reinigung einer Bondoberfläche kann also auch durch mehrere der genannten Verfahren durchgeführt werden. Die Reinigung kann an einem Chip durchgeführt werden oder an mehreren Chips gleichzeitig. Insbesondere können einzelne Chips beim Transport zwischen zwei Stationen gereinigt werden.

### Selbstausrichtung

In einer bevorzugten Ausführungsform werden die Chips positioniert und es erfolgt eine Selbstausrichtung der Chips. Unter Selbstausrichtung (engl.: self alignment) versteht man einen durch physikalische Gesetze der Minimierung getriebenen Positionierungsvorgang eines Objekts, im vorliegenden Fall eines Chips.

Die Selbstpositionierung erfolgt vorzugsweise dadurch, dass der Chip auf einer Bondoberfläche mit extrem geringer Haftreibung, insbesondere hervorgerufen durch eine auf der Bondoberfläche abgeschieden Flüssigkeit, in eine, insbesondere zentrische, Position zwischen Merkmalen der Bondoberfläche getrieben wird.

Denkbar wäre beispielsweise, dass sich auf der Bondoberfläche beispielsweise vier metallische Bereiche, insbesondere metallische Bondflächen wie Kontaktpads, insbesondere als Teil einer Hybridbond Oberfläche oder Vias, befinden. Der Chip besitzt an seiner Bondoberfläche ebenfalls vier Bereiche. Legt man einen solchen Chip auf eine Flüssigkeit, so ist davon auszugehen, dass sich hydrophilere Bereiche über hydrophileren Bereichen und hydrophobere Bereiche über hydrophoberen Bereichen positionieren werden. Es wird daher zu einer Ausrichtung kommen, bei der sich die metallischen Bereiche der Hybridbondoberflächen zur Deckung bringen werden.

Dem Fachmann auf dem Gebiet ist klar, dass eine derartige Selbstausrichtung umso besser erfolgen kann, je höher die Symmetrie der an der Selbstausrichtung beteiligten Strukturen ist. Dazu gehören die Geometrie des Chips, die Abstände zwischen den metallischen Bereichen der Hybridbondoberflächen, die Form der metallischen Bereiche etc. Vorzugsweise sollte der Chip quadratisch sein. Des Weiteren sollten mit Vorzug die metallischen Bereiche der Hybridbondoberfläche ebenfalls an den Ecken eines gedachten Quadrates liegen. Ein weiterer Vorteil wäre gegeben, wenn der Unterschied zwischen der Hydrophilität und Hydrophobizität der entsprechenden Hybridbondbereiche möglichst groß ist. Ein Maß für die Hydrophobizität bzw. Hydrophilität ist der Kontaktwinkel, der sich zwischen einem Testflüssigkeitstropfen, insbesondere Wasser, und der zu vermessenden Oberfläche ausbildet. Hydrophile Oberflächen verflachen den Flüssigkeitstropfen, da die Adhäsionskräftezwischen der Flüssigkeit und der Oberfläche über die Kohäsionskräfte der Flüssigkeit dominieren und bilden daher niedrige Kontaktwinkel. Hydrophobe Oberflächen führen zu einer kugelförmigeren Gestalt des Flüssigkeitstropfens, da die Kohäsionskräfte der Flüssigkeit über die Adhäsionskräfte zwischen der Flüssigkeit und der Oberfläche dominieren. Vorzugsweise ist die Kontaktwinkeldifferenz zwischen den beiden unterschiedlichen genannten Hybridbondbereiche größer als 1°, vorzugsweise größer als 5°, noch bevorzugter größer als 25°, am bevorzugtesten größer als 50°, am allerbevorzugtesten größer als 100°.

Die auf die Bondoberfläche aufgebrachte Flüssigkeitsschicht besitzt eine Dicke von weniger als 2 mm, vorzugsweise weniger als 1.5 mm, noch bevorzugter weniger als 1 mm, am bevorzugtesten weniger als 0.5 mm, am allerbevorzugtesten weniger als 0.1 mm. Bei der Flüssigkeit handelt es sich vorzugsweise um Wasser. Denkbar ist aber auch die Verwendung jeder anderen Flüssigkeit wie
- Alkohole
- Ether
- Säuren
- Basen

Insbesondere Ether besitzen einen sehr hohen Dampfdruck und verdampfen daher nahezu restlos von der Oberfläche, was automatisch zu einer Entfernung der Flüssigkeit nach der erzielten Selbstausrichtung führt. Mit Vorteil entsteht nach dem Entfernen der Flüssigkeit zwischen den Oberflächen automatisch ein Pre-bond.

In einer besonderen Ausführungsform befinden sich auf der Bondoberfläche des Substrats und/oder des Chips, insbesondere in den dielektrischen Bereichen, Rillen, welche die Entfernung der Flüssigkeit nach der Selbstausrichtung des Chips erleichtern oder erst ermöglichen. Diese Rillen führen mit Vorzug aus Bereich der Chipoberfläche an den Rand des Chips, so dass die Flüssigkeit nach außen durch Verfließen und oder Verdampfen entfernt, vorzugsweise automatisch, mit größerem Vorzug mit Unterstützung der Schwerkraft, die zum Hinauspressen der Flüssigkeit führt, entfernt werden kann.

### Bondvorrichtungen und -verfahren

Es werden mehrere Vorrichtungen und Prozesse zum Bonden von Chips offenbart. Die Verfahren lassen sich in Einzelbondverfahren und kollektive Bondverfahren einteilen. Die entsprechenden Vorrichtungen sind daher Vorrichtungen zum Einzelbonden bzw. zum Kollektivbonden. Allen Verfahren und Vorrichtungen ist gemein, dass die Bondoberflächen der Chips bis zum Bondvorgang kontaminationsfrei sein müssen. Die Prozessschritte und Anlagen zum Erreichen dieses Ziels werden im Folgenden genauer beschrieben.

### Einzelbondvorrichtungen und -verfahren

Unter einem Einzelbondverfahren versteht man die im Stand der Technik üblichen Vorgänge, um Chips einzeln, d.h. nacheinander, auf anderen Chips (C2C) oder auf einem Wafer (C2W) zu platzieren. Derartige Verfahren haben den Vorteil, dass Chips unterschiedlicher Größe und/oder unterschiedlicher Funktionalität gebondet werden können.

### Vereinzelung auf einer Folie

In einem ersten beispielhaften Verfahren wird ein Substrat auf einem Träger, insbesondere einer Folie (engl.: tape) fixiert und dort in Chips vereinzelt. Die Folie wird im weiteren Verlauf der Druckschrift als exemplarisches Beispiel verwendet. Denkbar ist allerdings auch die Verwendung eines starren Trägers. Die Chips werden also erst erstellt, nachdem die Fixierung des Substrats auf der Folie erfolgt ist.

In einem ersten Prozessschritt des Verfahrens erfolgt die Fixierung des Trägers, insbesondere der Folie, auf einer Fixierung, insbesondere einem Rahmen (engl.: dicing frame). Handelt es sich bei dem Träger um einen starren Träger, kann auf diesen Prozessschritt verzichtet werden bzw. der starre Träger kann auf einem Substrathalter/Trägerhalter fixiert werden. In einem zweiten, optionalen, Prozessschritt wird die Bondoberfläche des Substrats, aus dem die späteren Bondoberflächen der Chips entstehen, gereinigt. Bei der Reinigung kann es sich um eine der bereits genannten Reinigungsarten handeln. Insbesondere erfolgt die Reinigung durch Plasma und/oder Flüssigkeiten und/oder Gase. Eine Plasmabehandlung führt vorzugsweise zusätzlich zu einer Plasmaaktivierung der Bondoberfläche. Die Bondoberfläche muss nur dann gereinigt werden, wenn sie durch vorhergehende Prozesse so verunreinigt wurde, dass die Kontaminationen auf die Folie mit übertragen werden, oder Kontaminationen vorhanden sind, die später das Ausbilden eines Direktbonds verhindern und / oder beeinträchtigen würden. Vorzugsweise erfolgt allerdings immer eine Reinigung der Bondoberfläche des Substrats vor der Fixierung.

In einem dritten Prozessschritt erfolgt die Fixierung des Substrats mit seiner, insbesondere gereinigten, mit Vorzug plasmaaktivierten, Bondoberfläche auf dem Träger. Die Folie ist dabei so gestaltet, dass die Kontaminierung der Bondoberfläche nach der Entfernung des Substrats von dem Träger möglichst gering ist. Handelt es sich bei dem Träger um einen starren Träger, kann es nötig sein, die Trägeroberfläche vor der Fixierung des Substrats mit einer Schutzschicht zu versehen. Bei Folien ist eine derartige Schutzschicht meistens bereits vorhanden.

Des Weiteren dient der Träger ab dem Zeitpunkt der Kontaktierung der Bondoberfläche auch als deren Schutz und verhindert eine Kontaminierung der Bondoberfläche. Vorzugsweise ist der Träger zumindest im Zentrum des Substrats größtenteils so beschichtet, dass eine niedrige Adhäsion zwischen der Bondoberfläche des Substrats und dem Träger herrscht, während der Träger im peripheren Bereich des Substrats durchaus eine haftende Eigenschaft besitzen kann. Die Bereiche mit hoher Haftfestigkeit, also mit einer höheren Klebekraft, werden wahrscheinlich eine Kontamination an der Substratperipherie erzeugen, die vorzugsweise vernachlässigt werden kann, solange keine Bereiche der Bondoberfläche betroffen sind, aus denen später Chips gefertigt werden. Mit Vorzug ist die Folie so gestaltet, dass die Haftkraft durch Energieeintrag in die Folie (UV, Wärme) abnimmt und so die Chips später leichter abgenommen werden können. Derartige Folien sind im Stand der Technik bekannt.

Mit Vorzug werden für den Prozess jedoch besonders kontaminationsarme Folien verwendet.

Mit Vorzug weisen die Folien Kleber auf, die nicht in die Bondoberfläche, insbesondere in die Reservoirs, die durch die zuvor durchgeführte Plasma Aktivierung erzeugt wurden, eindringen können. Mit Vorzug wird dies dadurch gewährleistet, dass die Kleber eine sehr hohe Viskosität aufweisen, die ein Eindringen in die nano-poröse Oberfläche verhindert. Noch bevorzugter sind die Moleküle des Klebers so groß, dass ein Eindringen in die Poren aufgrund der großen Moleküle nicht möglich ist. Die Poren sind insbesondere kleiner als 10 nm, noch bevorzugter kleiner als 5 nm, am bevorzugtesten kleiner als 1 nm, noch bevorzugter kleiner als 0.5 nm, am allerbevorzugtesten kleiner als 0.2 nm. Die Porengrößen sind auch in der WO2012100786A1 offenbart. Am bevorzugtesten ist es, dass die Kleber Feststoffe sind, die in einer Polymer Matrix gebunden sind. Mit Vorzug kann durch die derartige Gestaltung der Kleber nach dem Entfernen der Folie auf eine Reinigung mit Lösungsmittel verzichtet werden und so ein Einlagern von Lösungsmittel im Reservoir, welches durch Plasma Aktivierung an der Oberfläche der Bondoberflächen erzeugt wurde, verhindert werden. Dies resultiert in verbesserten Bonding Ergebnissen, da ein Ausgasen der Lösungsmittel nach dem Bonden und somit Blasenbildung in der Bondgrenzfläche verhindert werden kann.

Die Erzeugung eines derartigen Reservoirs wird in den Druckschriften WO2012100786A1, WO2012136267A1, WO2012136268A1, WO2012136266A1 und WO2014015899A1 offenbart.

In einer ganz bevorzugten Ausführungsform ist der Träger allerdings so beschichtet, dass er das Substrat vollflächig fixieren kann, keine Kontamination auf dem Substrat hinterlässt und die später erzeugten Chips leicht entfernt werden können.

In einem vierten Prozessschritt wird das Substrat vereinzelt. Die Vereinzelung kann durch jedes beliebige Verfahren durchgeführt werden, sofern es die Bondoberfläche nicht verunreinigt. Im weiteren Verlauf der Druckschrift wird auf einige Vereinzelungsverfahren näher eingegangen werden, mit deren Hilfe die Reinhaltung der Bondoberfläche während der Vereinzelung gewährleistet wird.

In einem fünften Prozessschritt werden die vereinzelten Chips durch eine Maschine, insbesondere einen Chipbonder, vom Träger entfernt. In einer besonders bevorzugten Ausführungsform erfolgt während der Entfernung und/oder während dem Transport des Chips zu einer weiteren Position, insbesondere der Bondposition, eine weitere, insbesondere kontinuierliche Reinigung der Bondoberfläche des Chips. Diese Reinigung erfolgt vorzugsweise mit Plasma. Die Chips durchlaufen dabei entweder einen Bereich, in dem diese Reinigung erfolgt oder die Entnahme der Chips vom Träger erfolgt in einem Raum, in dem diese Reinigungseigenschaft automatisch erfolgt. So ist es beispielsweise denkbar, dass die Chips in einer Plasmakammer vom Chipbonder vom Träger entnommen werden. Mit größerem Vorzug werden die Chips nach dem Abnehmen vom Träger an einer atmosphärischen Plasma-Quelle vorbei bewegt. Insbesondere wird Sauerstoff-Plasma verwendet, welches mit Vorzug zum Veraschen von Rückständen führt.

In einem sechsten Prozessschritt wird die Bondoberfläche des transportierten, vereinzelten Chips durch einen Bond, insbesondere einen Direktbond bzw. Hybridbond, mit einer zweiten Bondoberfläche verbondet. Dem Bondvorgang geht dabei ein, im Allgemeinen relativ zügig durchgeführter, Ausrichtungsprozess des Chips in Bezug zu der zweiten Bondoberfläche, zu der er gebondet werden soll, voraus. Verbesserungen zum optimalen Bonden werden in anderen Bereichen der Druckschrift genauer erwähnt. Mit Vorzug dauert dieser Ausrichtungsprozess weniger als 5 Sekunden, bevorzugter weniger als 2 Sekunden, am bevorzugtesten weniger als 1 Sekunde.

### Verfahren zur Vereinzelung

Ein wesentlicher Aspekt der Ausführungsform besteht in der Reinhaltung der Bondoberfläche eines Substrats bzw. der daraus vereinzelten Chips. Um die Reinheit der Bondoberfläche zu gewährleisten, müssen auch die Vereinzelungsprozesse eine möglichst geringe Kontamination verursachen. Insbesondere dürfen bei der Vereinzelung eines Substrats keine Grate entstehen. Das kann durch mehrere unterschiedliche Prozesse gewährleistet werden.

In einem ersten möglichen Prozess, dem sogenannten stealth dicing, verändert ein fokussierter Laserstrahl die Materialeigenschaften derart, dass eine leichte Trennung der Chips erfolgen kann. Der Vorteil besteht vor allem in dem Verzicht auf mechanische Trennmittel wie Trennscheiben. Die grundsätzliche Funktionsweise des Stealth Dicing Prozesses ist im Stand der Technik bekannt.

In einem zweiten möglichen Prozess werden die Chips durch die Verwendung von Plasma voneinander getrennt.

In einem dritten möglichen Prozess werden die Chips durch die Verwendung mechanischer Trennmittel voneinander getrennt. Hier werden, in einer ganz bevorzugten Ausführung, vor einer optionalen Reinigung der Bondoberfläche und der Fixierung des Substrats auf dem Träger, Fugen auf der Bondseite erzeugt. Beim Vereinzelungsvorgang von der Rückseite des Substrats treffen die mechanischen Trennmittel dann auf die vorgefertigten Fugen. Die Fugen verhindern damit durch das vorzeitige Erreichen der mechanischen Trennmittel im Leerraum eine Kontamination der Bondoberfläche der einzelnen Chips.

Der Fugen können vorzugsweise auch bei den zuvor genannten Trennverfahren verwendet werden, da auch diese zu Verunreinigungen an der Kante und / oder Graten führen können. Insbesondere, wenn beispielsweise aufgrund des Schichtaufbaus der Chips der Bruch, insbesondere beim stealth dicing, nicht kontinuierlich vertikal durch den Wafer läuft. Insbesondere werden die Fugen geschaffen, um zumindest die Ausbildung eines Grats an der Bondingoberfläche zu vermeiden.

Die Fugen können auch das Resultat eines Maskierungsprozesses sein, der bei einer Abscheidung eines Materials auf einer Oberfläche angewandt wird. Bei einem solchen Prozess wird an den maskierten Stellen kein Material abgeschieden. Die Maskierten Bereiche bilden dann die Fugen.

### Kollektivbondvorrichtungen und -verfahren

Unter gewissen Umständen kann es nachteilig sein, Chips durch ein Einzelbondverfahren zu Bonden. Insbesondere wenn die Bondoberflächen der Chips gereinigt werden müssen um eine hohe Bondqualität zu erzielen, kann es von Vorteil sein, alle Chips zuerst so auf einem Träger zu positionieren, dass die spätere Bondoberfläche nach oben zeigt. In dieser Vorfixierung können alle Bondoberflächen der Chips dann auf einmal, insbesondere in einer dafür vorgesehenen Maschine, gereinigt und vorbehandelt werden. In einem weiteren Prozessschritt werden dann alle Chips auf einmal auf das eigentlich zu bondende Substrat bzw. die eigentlich zu bondenden Chips gebondet.

Ein wesentlich zu erfüllendes Qualitätsmerkmal bei einem solchen kollektiven Bond stellt die Planarität der, von allen Bondoberflächen aller Chips gebildeten, Bondebene dar. Die Bondoberflächen aller Chips müssen im Idealfall alle miteinander koinzidieren.

### Temporärträger

Der folgende Prozess beschreibt die Herstellung eines Temporärträgers mit mehreren Chips, deren Bondoberflächen miteinander koinzidieren, um einen kollektiven Bondvorgang durchzuführen.

In einem ersten Prozessschritt wird ein erster Träger, insbesondere ein Trägersubstrat, am bevorzugtesten ein Trägerwafer, noch bevorzugter eine Folie auf einem Trennrahmen (engl.: dicing frame) mit einer Schutzschicht beschichtet. Insbesondere bei der Verwendung einer Folie ist es denkbar, dass die Schutzschicht bereits auf die Folie aufgebracht wurde. Die Beschichtung des Trägers kann ansonsten mit den üblichen, bekannten Beschichtungsverfahren wie Schleuderbelackung, Sprühbelackung, Laminierung etc. erfolgen.

Alternativ ist es auch denkbar, die Oberfläche der Chips mit einer Schutzschicht zu versehen. Dies kann bereits vor dem Ausschneiden der Chips aus dem Wafer geschehen.

In einem zweiten Prozessschritt werden mehrere Chips mit einer sehr hohen Ausrichtungsgenauigkeit auf dem ersten Träger fixiert. Die Ausrichtung erfolgt insbesondere mit Hilfe von Ausrichtungsmarken und optischen Systemen. Die Ausrichtungsgenauigkeit ist dabei besser als 1mm, vorzugsweise besser als 100 µm, noch bevorzugter besser als 10 µm, am bevorzugtesten besser als 1 µm, am allerbevorzugtesten besser als 100 nm.

Die Fixierung erfolgt über die spätere Bondoberfläche der Chips. Die Bondoberflächen der Chips sollten möglichst miteinander koinzidieren. Des Weiteren sollte die Schutzschicht möglichst dünn sein, eine möglichst geringe Viskosität besitzen und einen möglichst hohe Elastizität besitzen, um zu verhindern, dass die Chips unterschiedlich tief in die Schicht eindringen und so die Koinzidenz Ihrer Bondoberflächen zerstören. Vorzugsweise sollte die Dicke der Schutzschicht möglichst gering sein, um ein elastisches Verhalten weitestgehend auszuschalten. Der erste Träger wirkt demnach als unendlich steifer Widerstand, die Schutzschicht ausschließlich als Separator zwischen Bondoberfläche und erstem Träger.

Der E-Modul einer Folie liegt dabei zwischen 1 GPa und 1000 GPa, bevorzugt zwischen 1 GPa und 500 GPa, mit größerem Vorzug zwischen 1 GPa und 100 GPa, mit größtem Vorzug zwischen 1 GPa und 50 GPa, mit allergrößtem Vorzug zwischen 1 GPa und 20 GPa. Der E-Modul von Polyamiden liegt beispielsweise zwischen 3 und 6 GPa.

Der E-Modul eines steiferen Trägers liegt dabei zwischen 1 GPa und 1000 GPa, bevorzugt zwischen 10 GPa und 1000 GPa, mit größerem Vorzug zwischen 25 GPa und 1000 GPa, mit größtem Vorzug zwischen 50 GPa und 1000 GPa, am bevorzugtesten zwischen 100 GPa und 1000 GPa. Der E-Modul von einigen Stahlsorten liegt beispielsweise bei um die 200 GPa.

In einem dritten Prozessschritt wird ein zweiter Träger, insbesondere ein Trägersubstrat, am bevorzugtesten ein Trägerwafer, mit einem Adhäsiv, beschichtet. Bei dem zweiten Träger handelt es sich um den Temporärträger. Im Gegensatz zur Schutzschicht aus dem zweiten Prozessschritt sollte das Adhäsiv elastisch und/oder plastisch anpassungsfähig sein, um mögliche Höhenunterschiede der Chips so auszugleichen, dass die Koinzidenz der Bondoberflächen der Chips nicht verloren geht. Das Adhäsiv sollte daher eine möglichst geringe Viskosität und eine Möglichkeit der bleibenden Verformung besitzen.

Die Viskosität des Adhäsivs liegt bei Raumtemperatur zwischen 10E6 mPa*s und 1 mPa*s, vorzugsweise zwischen 10E5 mPa*s und 1 mPa*s, noch bevorzugter zwischen 10E4 mPa*s und 1 mPa*s, am bevorzugtesten zwischen 10E3 mPa*s und 1 mPa*s.

In einem vierten Prozessschritt werden die, den Bondoberflächen der Chips gegenüberliegenden, Rückseitenoberflächen der Chips mit dem Temporärträger verbunden. Dabei bleibt die Koinzidenz der Bondoberflächen der Chips auf der ersten Trägerseite erhalten, während die Rückseitenoberflächen das Adhäsiv auf dem Temporärträger, falls nötig, entsprechend verformen, insbesondere durch die vorzugsweise niedrige Viskosität, verfließen. Nach dem Bondvorgang kann daher die Dicke des Adhäsivs zwischen einem Chip und dem Temporärträger von Chip zu Chip unterschiedlich sein. In einer Erweiterung ist die Entfernung des Adhäsivs zwischen den Chips möglich. Vorzugsweise erfolgt eine Ausrichtung zwischen dem ersten Träger und dem Temporärträger über Ausrichtungsmarken, die sich auf dem ersten Träger und dem Temporärträger befinden. Denkbar ist auch, dass sich Ausrichtungsmarken auf den Oberflächen der Chips befinden und diese zu Ausrichtungsmarken auf dem Temporärträger ausgerichtet werden. Ausrichtungsanlagen (engl.: aligner) zur Ausrichtung von Substraten werden in den Druckschriften US6214692B1, WO2015082020A1, WO2014202106A1 ausführlich beschrieben.

In einem fünften Prozessschritt wird der erste Träger mit der Schutzschicht entfernt. Insbesondere ist daher die Haftwirkung zwischen dem Adhäsiv, dem Temporärträger und den Chips höher als die Haftreibung zwischen der Schutzschicht und der Bondoberfläche der Chips. In einer besonders bevorzugten Ausführungsform ist die Schutzschicht so konzipiert, dass die Loslösung von der Bondoberfläche des Chips, insbesondere vollständig, kontaminationsfrei erfolgt. Handelt es sich bei dem ersten Träger um eine Folie, kann diese abgezogen werden, was die Entfernung erleichtert. Es kann auch notwendig sein, die Schutzschicht mit Hilfe von Chemikalien und/oder elektromagnetischer Strahlung, insbesondere

UV-Licht, sichtbarem Licht oder Infrarotlicht und/oder Wärme chemisch oder hinsichtlich der mechanischen Eigenschaften zu verändern, damit sie ihre Hafteigenschaft verliert oder zumindest verringert.

Die Bondstärke zwischen der Schutzschicht und den Chips ist dabei kleiner als 1 J/m2, vorzugsweise kleiner als 0.1 J/m2, noch bevorzugter kleiner als 0.01 J/m2, am bevorzugtesten kleiner als 0.001 J/m2, am allerbevorzugtesten kleiner als 0.0001 J/m2.

In einem sechsten, optionalen Prozessschritt erfolgt die, insbesondere gleichzeitige Reinigung und/oder Plasmaaktivierung der freigelegten Bondoberflächen der Chips. Diese Maßnahme ist vor allem dann von Bedeutung, wenn die Entfernung des ersten Trägers von den Bondoberflächen der Chips nicht vollständig kontaminationsfrei erfolgt ist. Die Reinigung aller Chips kann diesmal insbesondere gleichzeitig erfolgen, was den Durchsatz des Verfahrens erhöht.

In einem siebten Prozessschritt erfolgt dann der gleichzeitige Bondvorgang aller auf dem Temporärträger fixierten Chips auf einem Produktsubstrat, insbesondere einem Wafer. Darunter fällt auch die Möglichkeit, die Chips auf dem Temporärträger auf Chips zu bonden, die sich bereits auf dem Produktsubstrat befinden. Dadurch wird eine Möglichkeit geschaffen, einen Chipstapel auf einem Produktsubstrat sukzessive aufzubauen. Vorzugsweise erfolgt eine Ausrichtung zwischen dem Temporärträger und dem Produktsubstrat über Ausrichtungsmarken, die sich auf dem Träger und dem Produktsubstrat befinden. Denkbar ist auch, dass sich Ausrichtungsmarken auf den Bondoberflächen der Chips befinden und diese zu Ausrichtungsmarken auf dem Produktsubstrat ausgerichtet werden.

In einem achten Prozessschritt erfolgt die Entfernung des Temporärträgers von den Chips. Es kann notwendig sein, das Adhäsiv mit Hilfe von Chemikalien und/oder elektromagnetischer Strahlung, insbesondere UV-Licht, sichtbarem Licht oder Infrarotlicht, und/oder Wärme chemisch oder hinsichtlich der mechanischen Eigenschaften, insbesondere der Viskosität zu verändern, damit es seine Hafteigenschaft verliert. Mit besonderem Vorzug handelt es sich bei dem Temporärträger um einen Träger, der für die Photonen aus einem spezifischen Wellenlängengebiet des EM Spektrums, transparent ist. Vorzugsweise handelt es sich um einen Glasträger. Dadurch können Adhäsive verwendet werden, die mit Hilfe eines Lasers von der Rückseite zerstört werden können, sodass eine Debondmöglichkeit des Temporärträgers von dessen Rückseite her möglich ist.

In einem neunten Prozessschritt erfolgt die Reinigung der Rückseitenoberfläche des Chips vom Adhäsiv durch eines der genannten Reinigungsverfahren. Nach diesem Prozessschritt können beliebige weitere Chips auf den vorhandenen Chips gestapelt werden um so einen Chipstapel auf dem Produktsubstrat aufzubauen.

Die Positionierungsgenauigkeit der Chips auf dem ersten Träger gemäß dem Prozessschritt zwei sowie die Positionierung der Chips auf dem Temporärträger durch den kollektiven Bondvorgang gemäß Prozessschritt sieben wird vorzugsweise durch eine Selbstausrichtung der Chips ermöglicht bzw. zumindest unterstützt. Die Positionierungsgenauigkeit ist dabei besser als 1mm, vorzugsweise besser als 100 µm, noch bevorzugter besser als 10 µm, am bevorzugtesten besser als 1 µm, am allerbevorzugtesten besser als 100 nm. Die Unterstützung durch Selbstausrichtung kann nur dann erfolgen, wenn eine laterale Verschiebung der Chips relativ zum ersten Träger und/oder relativ zum Temporärträger ermöglicht wird. Dazu müssen die Schutzschicht auf dem ersten Träger und/oder das Adhäsiv auf dem Temporärträger über entsprechend geringe Schubmoduli verfügen oder sogar eine plastische Verformung ermöglichen, sodass die Chips sich lateral verschieben können.

### Fixierträger

Anstatt den eben genannten Temporärträger zu verwenden, ist es denkbar, die Chips auf einem Fixierträger zu fixieren, welcher über entsprechend Fixierelemente verfügt. Bei den Fixierelementen kann es sich um
- Vakuumfixierungen
- Elektrostatische Fixierungen
- Magnetische Fixierungen
- Gelpackfixierungen
handeln. Die Chips können direkt mit ihrer Rückseitenoberflächen am Fixierträger fixiert werden. Nachteilig ist, dass im Gegensatz zum genannten Temporärträger kein Adhäsiv existiert, mit dessen Hilfe eine Vereinheitlichung der Bondoberflächen aller Chips in einer Ebene erfolgen kann. Höchstens die Nachgiebigkeit eines Gelpacks der genannten Gelpackfixierung ermöglicht einen ähnlichen Effekt. Insbesondere können die später beschriebenen Ejektorvorrichtungen auch als Fixierträger verwendet werden.

### Ejektorvorrichtungen

Im weiteren Verlauf der Druckschrift werden mehrere Vorrichtungen und Verfahren beschrieben, bei denen die Aufnahme und Fixierung von Chips notwendig ist. Alle offenbarten Verfahren und Vorrichtungen beziehen sich daher auf die bereits vereinzelten Chips und deren Handhabung, die immer so erfolgen soll, dass die Bondoberfläche möglichst nicht mehr kontaminiert wird. Diese als Ejektorvorrichtung bezeichneten Ausführungsformen haben primär die Aufgabe, eine Vielzahl von bereits vereinzelten Chips zu fixieren, um an ihnen einen Reinigungsprozess durchzuführen und ihre Bondoberfläche für den eigentlichen Bondvorgang vorzubereiten.

### Ejektorvorrichtungen mit Vertiefungsausführung

Eine erste Ejektorvorrichtung um die Bondoberfläche eines Chips zu behandeln und direkt einem Bondprozess zuzuführen besteht in der Lagerung der Chips in einem Träger. Der Träger verfügt über Vertiefungen, in welchen Chips positioniert und/oder fixiert werden können.

In einer bevorzugten Ausführungsform sind die Konturen der Vertiefungen kongruent zu den Konturen der Chips. In einer weiteren Variante können die Konturen der Vertiefungen auch von den Konturen der Chips abweichen. Insbesondere sind die Vertiefungen größer als die Chips. Dadurch wird der Zugang einer Reinigungsflüssigkeit und/oder eines Plasmas an die Seiten der Chips begünstigt. Der Abstand zwischen der Kontur des Chips und der Kontur der Vertiefung ist dabei kleiner als 5 mm, vorzugsweise kleiner als 1 mm, noch bevorzugter kleiner als 0.5 mm, am bevorzugtesten kleiner als 0.1 mm, am allerbevorzugtesten kleiner als 0.05 mm.

An den Bodenflächen der Vertiefungen befinden sich Durchgänge (im Folgenden auch Durchführungen genannt), insbesondere Bohrungen, durch die eine Hebevorrichtung die Chips anheben kann, um sie für einen Greifer (im Folgenden auch Greifkopf genannt) zugänglich zu machen. In einer besonders bevorzugten Ausführungsform entspricht die Höhe eines Chips genau der Tiefe der Vertiefung. Damit koinzidieren die zu reinigende Bondoberfläche und die Trägeroberfläche. Durch eine derartige Ausführungsform wird besonders ein mechanischer Reinigungsvorgang begünstigt. Da die Chips nicht aus der Vertiefung hervorragen, können sie nicht mechanisch beschädigt werden. Des Weiteren versinken sie nicht in der Vertiefung und können daher optimal von allen Arten von Reinigungsgeräten erreicht werden. Des Weiteren eignet sich die Ausführungsform optimal zur Plasmareinigung der Chips, da durch die Erzeugte nahtlose Ebenheit zwischen der Bondoberfläche und der Trägeroberfläche die Homogenität des verwendeten Plasmas sehr hoch ist. Durch die hohe Homogenität werden eine hohe Reproduzierbarkeit und vor allem eine gleichmäßige Reinigung, insbesondere eine gleichmäßige PlasmaAktivierung, der Bondoberflächen gewährleistet.

Alle in der Druckschrift vorgesehenen Träger, die in einer Plasmakammer Verwendung finden, sollten spezifische Eigenschaften besitzen. Insbesondere müssen die Träger aus einem leitfähigen Material bestehen. Die Träger bestehen daher vorzugsweise aus
- Einem Elektrika, insbesondere
   ∘ Einem Metall, insbesondere
   ∘ Einer Legierung, insbesondere
      ▪ Stahl
      ▪ Aluminium
      ▪ Rostfreien Stahl Legierungen
      ▪ Titan
   ∘ Einer leitfähigen Keramik, insbesondere
      ▪ Dotiertes SiC
      ▪ Dotiertes Si3N4

Metallische Träger werden vorzugsweise beschichtet um eine Kontamination der Chips durch die Metalle zu verhindern. Als Beschichtungen kommen vorzugsweise Dielektrika, insbesondere Oxide, Nitride oder Karbide in Frage. Mit Vorzug wird der Träger auch zweiteilig ausgeführt, so dass die Chips auf einer metallischen Scheibe sitzen und für die Plasmaaktivierung dann eine Blende aufgelegt wird, die aus einem Dielektrikum, insbesondere Si, SiC oder Si3N4 besteht. In diesem Fall hat die Blende ähnliche oder identische dielektrische Eigenschaften wie die Chips. Somit kann ein möglichst gleichmäßiges Plasma gewährleistet werden. Insbesondere besteht die Blende sogar aus demselben dielektrischen Material wie die Chips.

Der Absolutbetrag der Differenz von Chiphöhe h und der Tiefe t der Vertiefung ist kleiner als 1 mm, vorzugsweise kleiner als 0.5 mm, noch bevorzugter kleiner als 0.1 mm, am bevorzugtesten kleiner als 0.05 mm, am allerbevorzugtesten kleiner als 0.01 mm.

Durch die Ausführungsform können die Bondoberflächen mehrerer Chips gleichzeitig behandelt werden, was eine extreme Effizienzsteigerung der Reinigung bereits vereinzelter Chips zur Folge hat.

Nach dem Auswurf des Chips in eine wohldefinierte Höhe, wird ein Greifkopf verwendet, um den Chip aufzunehmen und zu transportieren. Dabei fixiert der Greifkopf den Chip nicht an der eben gereinigten Bondoberfläche, sondern an der, der Bondoberfläche gegenüberliegenden, Fixieroberfläche. Die Fixieroberfläche kann in diesen Prozessschritten insbesondere kontaminiert werden. Die Fixieroberfläche kann in weiteren Prozessschritten allerdings zu einer neuen Bondoberfläche werden, auf der ein weiterer Chip platziert werden kann, und muss dann entsprechend gereinigt werden.

Bei der beschriebenen Ejektorvorrichtung ist die Tiefe t der Vertiefung vorgegeben. Werden Chips mit leicht unterschiedlichen Chiphöhen h fixiert, koinzidieren ihre zu reinigenden Bondoberflächen nicht mehr miteinander. In diesem Fall ist denkbar, dass die Hebevorrichtungen eine Höhenkorrektur einiger Chips, insbesondere der Chips, deren Chiphöhen h kleiner sind als die Tiefen t der Vertiefungen, durchführt.

### Ejektorvorrichtung mit Aufsatzausführung

Eine weitere zweite Ejektorvorrichtung besteht aus einem Träger, in dem sich Durchgänge, insbesondere Bohrungen, befinden. Im Gegensatz zur vorherigen ersten Ejektorausführung verfügt diese Ejektorvorrichtung über keine Vertiefungen. Die zu reinigenden Chips werden direkt an der Trägeroberfläche fixiert. Insbesondere wird die umgebende Atmosphäre mit Hilfe von Dichtungen von den Durchgängen getrennt. Damit ist es möglich die Reinigung der Chips durchzuführen, ohne eine Kontaminierung der Durchgänge durch die Reinigungsmittel, beispielsweise Chemikalien wie Fluide oder Ionen aus dem Plasma, durchzuführen. Innerhalb des abgedichteten Raums können sich Fixierelemente befinden, welche die

Chips fixieren. Bei den Fixierelementen handelt es sich um mindestens eine der folgenden Fixierungen
- Vakuumfixierungen (bevorzugt)
- Elektrostatische Fixierungen
- Magnetische Fixierungen
- Klebefixierung,
- Mechanische Fixierungen (am wenigsten bevorzugt)

Am bevorzugtesten werden Vakuumfixierungen verwendet, welche den Durchgang sowie den Raum zwischen den Dichtungen evakuieren können und so für ein Anpressen des Chips auf die Dichtungen sorgen. Bei den Dichtungen kann es sich entweder um Festkörper, insbesondere um Polymere, handeln oder um, insbesondere hochviskose und/oder ausgehärtete, Polymere. Vorzugsweise handelt es sich bei den Dichtungen dann um Wachse, Adhäsive, Klebstoffe etc. Diese Polymere müssen regelmäßig ersetzt werden, da sie mit der Zeit, insbesondere durch durchgeführte Reinigungsprozesse, entfernt werden.

### Masken

In einer Erweiterung, insbesondere für die genannten Ejektorvorrichtungen, wird eine Maske mit einer Apertur verwendet um die Bondoberflächen von Chips gegen Kontamination zu schützen. Das Ergreifen der Chips erfolgt immer über Maschinenbauteile, die sich notwendigerweise über die Chips hinwegbewegen müssen. Neben dem eigentlichen Greifkopf und einem entsprechenden Arm, an dessen Ende sich der Greifkopf befindet, müssen auch Kabel und Leitungen mitbewegt werden. Alle diese Maschinenelemente tragen notwendigerweise zur Kontamination der Bondoberflächen der Chips bei, wenn sie sich über diese hinwegbewegen.

In einer besonders bevorzugten Ausführungsform erfolgt eine Relativbewegung zwischen der Maske mit Apertur und den Chips. Vorzugsweise bewegt sich die Vorrichtung, auf der sich die Chips befinden. Denkbar ist auch, dass sich die Maske bewegt. Für die Entnahme eines Chips wird die Apertur über den zu entnehmenden Chip positioniert. Die Hebevorrichtung hebt den zu bondenden Chip über die Maske hinweg. Auf der Oberseite der Maske entnimmt ein Greifkopf den Chip über seine Rückseitenoberfläche, ohne seine Bondoberfläche zu berühren, und transportiert ihn an eine Position, an welcher er weiterprozessiert wird. Insbesondere erfolgt als nächster Schritt eine Erfassung der Ausrichtungsmarken des Chips mit einer ersten Optik. Danach wird der Chip unter die zu bondende Position verfahren und danach, insbesondere mit Hilfe einer zweiten Optik, relativ zu der zu verbondenden Position hochgenau positioniert und gebondet. Es ist daher möglich, dass sich die Position, an welcher der Chip gebondet wird, weit außerhalb der Chipentnahme befindet. Des Weiteren kann der Chip bis zum eigentlichen Bondvorgang mehrere Stationen durchlaufen, insbesondere Ausrichtung und/oder Vermessung und/oder Reinigung, und/oder Teststation etc. Es wird während des gesamten Chiptransports nur die Rückseitenoberfläche des Chips berührt, aber niemals seine Bondoberfläche. Der Greifkopf fixiert daher den Chip vorzugsweise ab dem Zeitpunkt der Entnahme von der Hebevorrichtung bis zum Bondabschluss.

In einer speziellen Ausführungsform befindet sich das Produktsubstrat, auf dem ein Chip gebondet werden soll, direkt über den zu bondenden Chips. Sämtliche anderen Chips, und damit deren Bondoberflächen, werden wieder durch die Maskenoberfläche vor Verunreinigung geschützt. Der Ejektor entlädt den Chip von der Ejektorvorrichtung und bondet ihn direkt auf ein Produktsubstrat bzw. auf einen Chip/Chipstapel eines Produktsubstrats. Die Bondoberflächen des Produktsubstrats bzw. der Chips des Produktsubstrats sind dem Ejektor dabei direkt zugewandt, zeigen daher in Gravitationsrichtung. Durch die Maske wird eine Verschmutzung der Bondoberfläche der noch auszuwerfenden Chips auf der Ejektorvorrichtung verhindert. Diese Ausführungsform ist weniger bevorzugt als die oben genannte Ausführungsform, bei dem ein Greifkopf den Chip an eine andere Stelle transportiert und dort bondet, da in dieser Variante keine weiteren Prozessschritte an dem Chip durchgeführt werden können.

Die Maske selbst muss, für alle Ausführungsformen, dabei selbst kontaminationsfrei sein. Insbesondere kann die Maske zwischen einem Bestückungsprozess mit einer der genannten Reinigungsverfahren gereinigt werden. Die Maske wird vor allem für Bondvorgänge verwendet, bei denen ein mit Chips zu bestückendes Substratmit seiner Bondoberfläche in Gravitationsrichtung positioniert wird. Die Maske verhindert dabei die Übertragung von Kontaminationen des Substrats oder von sich bewegenden Maschinenelementen auf die, sich unter dem Substrat befindenden, Chips. Die Masken werden insbesondere mit den in der Druckschrift ausführlich beschriebenen Ejektorvorrichtungen verwendet. Bei diesen Ausführungsformen kann man vor allem auf ein Drehen, und damit eine Kontaktierung der Chips auf deren Bondoberflächen, verzichten. Die genauen Ausführungsformen werden in anderen Stellen der Druckschrift, sowie in einer Figur und der dazugehörenden Figurenbeschreibung ausführlich erläutert.

In Reinräumen herrscht des Weiteren eine Top-Down Strömung. Die Luft zirkuliert daher immer von höheren Lagen in tiefere Lagen und zieht dabei Staubpartikel mit sich. Die Strömungsrichtung wirkt sich ebenfalls nachteilig auf die Kontamination der Bondoberflächen aus. Denkbar ist, dass sich in der Nähe der Vorrichtungen, in welchen mehrere Chips mit den exponierten Bondoberfächen fixiert werden, insbesondere in den genannten Ejektorvorrichtungen oder Fixierträgern, Maschinen vorgesehen sind, die eine seitliche Strömung erzeugen, um Staubpartikel lateral abzuführen.

### Bondkopf

In einer weiteren erfindungsgemäßen Ausführungsform wird eine Fixiereinrichtung zum Fixieren und Bonden eines Chips beschrieben. Diese Fixiereinrichtung wird auch als Bondkopf (engl.: bond head) bezeichnet und beschreibt das Maschinenbauteil, dass für die Fixierung, den Transport und das Bonden des einzelnen Chips auf eine Bondoberfläche verantwortlich ist. Um die Vorteile einer sauberen Bondoberfläche am Chip ausnützen zu können ist es notwendig, den Bondvorgang soweit wie möglich steuern zu können. Insbesondere ist es unabdingbar, dass ein Chip nicht zuerst am Rand bondet, sondern dass sich eine Bondwelle vom Zentrum des Chips nach außen hin ausbreitet. Das Konzept der Bondwelle ist dem Fachmann bereits aus dem wafer-to-wafer (engl.: W2W) Bonden bekannt. Es wird hier auf die Druckschriften WO2014191033A1, PCT/EP2016053268, PCT/EP2016056249 und PCTEP2016069307 verwiesen, um nur einige zu nennen.

Im Gegensatz zu den genannten W2W Verfahren besitzen C2W Verfahren allerdings extrem hohe Durchsätze. Die Fixiereinrichtung bewegt sich mit sehr hoher Geschwindigkeit vom Aufnahmeort des Chips zur Bondposition und zurück. Durch die rasch zu erreichenden hohen Geschwindigkeiten sind auch die Beschleunigungen relativ hoch. Insbesondere ist auch die Beschleunigung in z-Richtung, d.h. normal zur Bondoberfläche sehr hoch. Diesen erwünschten physikalischen Tatbestand kann man benutzen um eine vollkommen neue Art von Fixiereinrichtung zu konstruieren, mit deren Hilfe man in der Lage ist, einen Chip nur Aufgrund der Massenträgheit konvex zu formen um damit sicherzustellen, dass das Zentrum der Bondoberfläche des Chips zuerst die zweite Bondoberfläche kontaktiert.

Der erfindungsgemäße Gedanke besteht darin, dass die Fixiereinrichtung über Federelemente an der Peripherie verfügt, deren Federkonstante kleiner ist als die Federkonstante eines zentrisch gelegenen Federelementes. In einer ganz besonderen erfindungsgemäßen Ausführungsformen wird die Fixierfläche peripher gar nicht unterstützt, d.h. es wird peripher auf Federelemente verzichtet.

Das Verhältnis der Federkonstante eines peripheren Federelementes zur Federkonstante eines zentrisch gelegenen Federelementes ist dabei kleiner als 1, vorzugsweise kleiner als 0.1, noch bevorzugter kleiner als 0.01, am bevorzugtesten kleiner als 0.0001, am allerbevorzugtesten kleiner als 0.00001.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: einen ersten Prozessschritt eines ersten Prozesses,
- Figur 1b: einen zweiten Prozessschritt eines ersten Prozesses,
- Figur 1c: einen dritten Prozessschritt eines ersten Prozesses,
- Figur 1d: einen vierten Prozessschritt eines ersten Prozesses,
- Figur 1e: einen fünften Prozessschritt eines ersten Prozesses,
- Figur 1f: einen sechsten Prozessschritt eines ersten Prozesses,
- Figur 1g: einen siebten Prozessschritt eines ersten Prozesses,
- Figur 2a: einen ersten Prozessschritt eines zweiten Prozesses,
- Figur 2b: einen zweiten Prozessschritt eines zweiten Prozesses,
- Figur 2c: einen dritten Prozessschritt eines zweiten Prozesses,
- Figur 2d: einen vierten Prozessschritt eines zweiten Prozesses,
- Figur 2e: einen fünften Prozessschritt eines zweiten Prozesses,
- Figur 2f: einen sechsten Prozessschritt eines zweiten Prozesses,
- Figur 2g: einen siebten Prozessschritt eines zweiten Prozesses,
- Figur 2h: einen achten Prozessschritt eines zweiten Prozesses,
- Figur 2i: einen neunten Prozessschritt eines zweiten Prozesses,
- Figur 3: eine erste Ejektorvorrichtung,
- Figur 4: eine zweite Ejektorvorrichtung,
- Figur 5: eine Maske mit Apertur in einer ersten Ausführungsform,
- Figur 6: eine Maske mit Apertur in einer zweiten Ausführungsform,
- Figur 7a: einen ersten Prozessschritt einer Selbstausrichtung,
- Figur 7b: einen zweiten Prozessschritt einer Selbstausrichtung,
- Figur 8a: einen erfindungsgemäßen ersten Prozessschritt eines Bondvorgangs mit erfindungsgemäßen Bondkopf,
- Figur 8b: einen erfindungsgemäßen zweiten Prozessschritt eines Bondvorgangs mit erfindungsgemäßen Bondkopf,

In den Figuren sind gleiche Bauteile oder Bauteile mit der gleichen Funktion mit den gleichen Bezugszeichen gekennzeichnet.

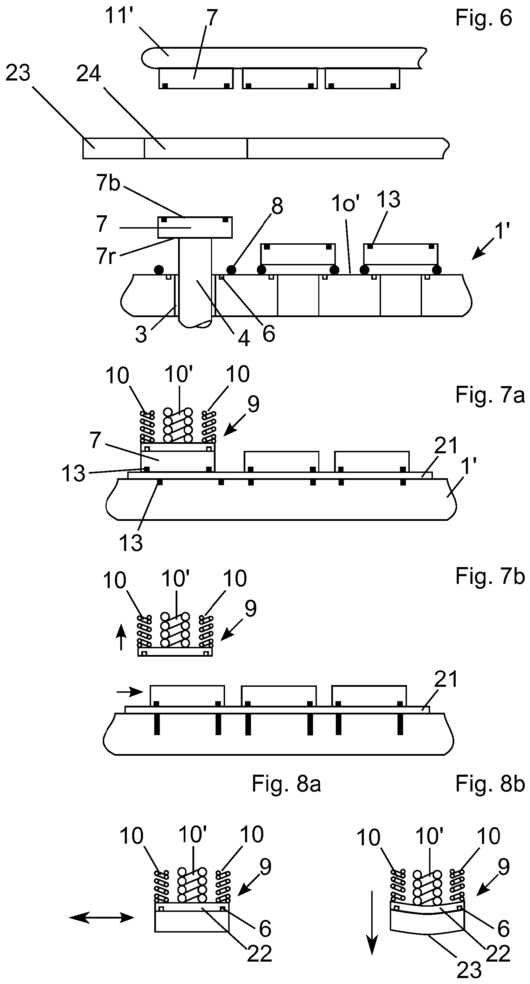

In dieser Beschreibung sind nur die Ausführungsformen, die den Figuren 8a,b entsprechen, Ausführungsformen der Erfindung. Alle anderen Ausführungsformen und Beispiele dienen dem Verständnis der beanspruchten Erfindung.

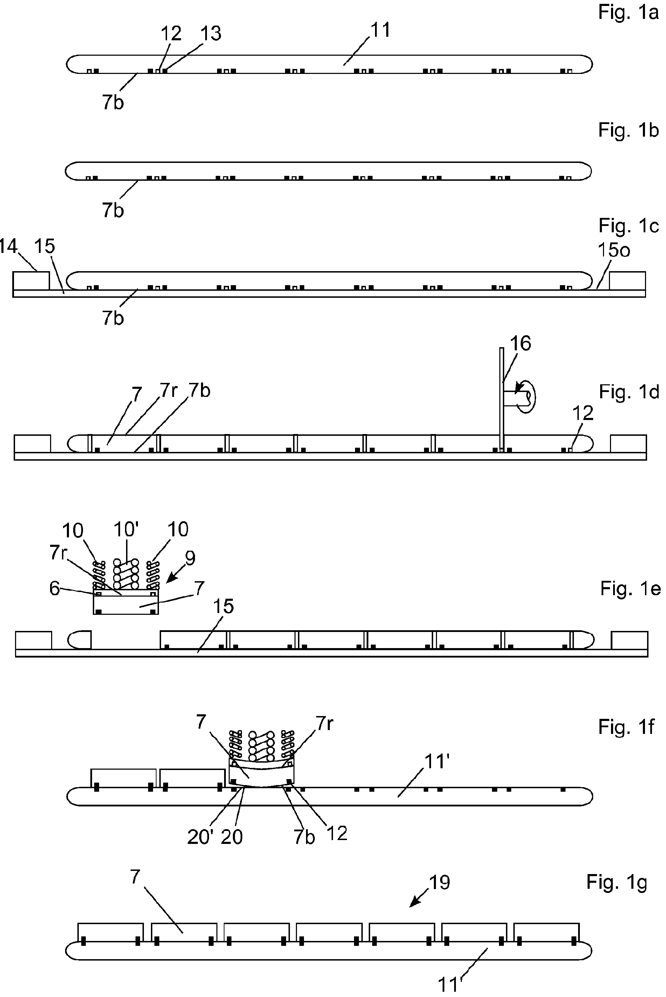

Die **Figur 1a** zeigt einen ersten Prozessschritt eines ersten Prozesses zur Erzeugung eines Endprodukts 19 nach dem ersten Prozess. Auf einem Substrat 11 werden alle Vorbereitungen für die Herstellung mehrerer Chips durchgeführt. Zu den Vorbereitungen gehört die Herstellung aller funktionalen Eigenschaften des Chips, insbesondere Kontakte 13. Des Weiteren können Fugen 12 vorgeschnitten werden, um den späteren Trennprozess zu begünstigen. Durch die Durchführung aller Vorbereitungsschritte kann eine Bondoberfläche 7b bereits kontaminiert sein.

Die **Figur 1b** zeigt einen zweiten Prozessschritt des ersten Prozesses, einen Reinigungsschritt der Bondoberfläche 7b. Insbesondere wird die Bondoberfläche 7b durch Plasma und/oder nasschemische Verfahren gereinigt und/oder aktiviert.

Die **Figur 1c** zeigt einen dritten Prozessschritt des ersten Prozesses, bei dem eine Fixierung des Substrats 11 auf einem Träger, insbesondere eine Folie 15, erfolgt. Vorzugsweise ist eine Folienoberfläche 15o so gestaltet, dass eine Fixierung des Substrats 11 über die Bondoberfläche 7b erfolgt, eine spätere Entfernung der Folie 15 allerdings keine Rückstände auf der Bondoberfläche 7b hinterlässt.

Die **Figur 1d** zeigt einen vierten Prozessschritt des ersten Prozesses, bei dem eine Trennung des Substrats 11 in einzelne Chips 7 erfolgt. Es darf die Bondoberfläche 7b der Chips 7 dabei nicht kontaminiert werden. Vorzugsweise werden daher, insbesondere bei einer mechanischen Trennung durch eine Trennvorrichtung 16, die Fugen 12 im Substrat 11 vorgesehen, um den Trennprozess bereits oberhalb der Bondoberfläche 7b beenden zu können. Denkbar sind auch Trennungen durch Laser, insbesondere durch die bekannte Stealth Technik, durch Chemikalien, insbesondere durch Ätzen, vorzugsweise durch Trockenätzen, durch Plasma etc.

Die **Figur 1e** zeigt einen fünften Prozessschritt des ersten Prozesses, bei dem der Chip 7 durch einen Bondkopf 9, an dem sich Fixierungen 6 befinden, von der Folie 15 entfernt wird. Der Bondkopf 9 fixiert den Chip 7 dabei an seiner Rückseitenfläche 7r, sodass keine Kontamination an der Bondoberfläche 7b erfolgt.

Die **Figur 1f** zeigt einen sechsten Prozessschritt des ersten Prozesses, bei dem der Bondkopf 9, nachdem eine Ausrichtung des Chips 7 relativ zu einem weiteren Substrat 11' erfolgte, auf das weitere Substrat 11' bondet. Die Bondoberfläche 7b ist dabei vorzugsweise eine Hybridoberfläche, die aus einem dielektrischen Oberflächenbereich 20 und einem elektrischen Oberflächenbereich, repräsentiert durch die Kontakte 13, besteht. Im Fall einer solchen Hybridbondoberfläche, erfolgt ein sogenannter Prebond zwischen dem dielektrischen Oberflächenbereich 20 der Bondoberfläche 7b des Chips 7 und einem dielektrischen Oberflächenbereich 20' des Substrats 11'.

Die **Figur 1g** zeigt das Endprodukt 19 des ersten Prozesses, bestehend aus dem Substrat 11' und mehreren Chips 7. Denkbar ist die Wiederholung der genannten Prozessschritte, um weitere Schichten von Chips 7 auf die erste Schicht von Chips 7 zu stapeln.

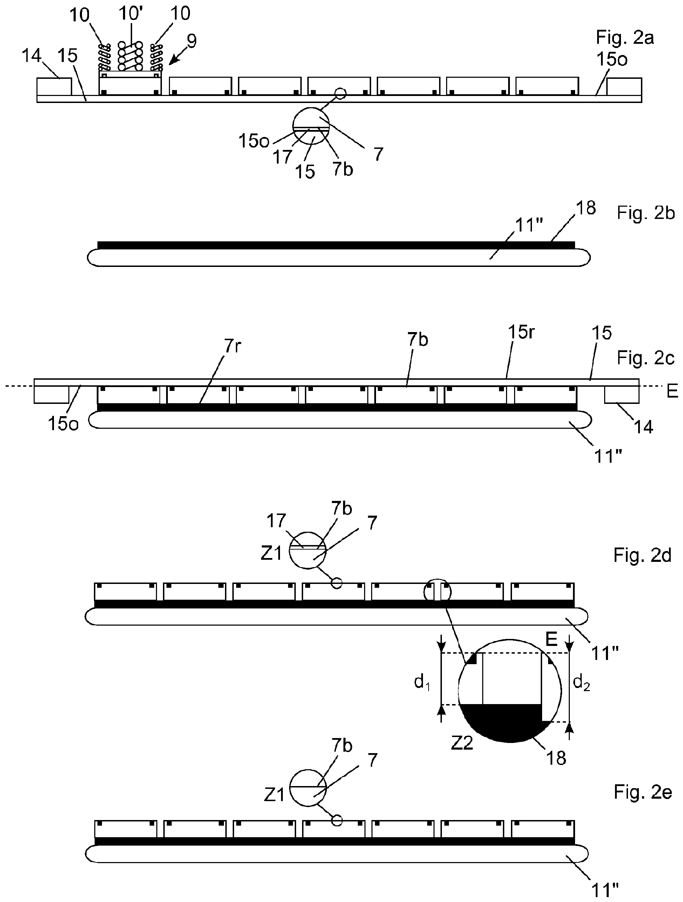

Die **Figur 2a** zeigt einen ersten Prozessschritt eines zweiten Prozesses, bei dem mehrere bereits vereinzelte Chips 7 mit der Bondoberfläche 7b auf einem Träger, insbesondere einer Folie 15, fixiert werden. Die Bondoberflächen 7b der Chips 7 mussten in einem vorhergehenden Prozess bereits gereinigt und/oder aktiviert worden sein. Die Chips 7 werden vorzugsweise durch einen Bondkopf 9 eines Chipbonders ausgerichtet und positioniert. Die Vergrößerung zeigt die Grenzfläche zwischen der Bondoberfläche 7b eines Chips 7 und der Folienoberfläche 15o der Folie 15. Auf der Folienoberfläche 15o kann sich eine Schutzschicht 17 befinden, die vorzugsweise auch Klebeeigenschaften besitzt. Mit besonderem Vorzug ist die Hafteigenschaft zwischen der Schutzschicht 17 und der Folienoberfläche 15o allerdings größer als die Hafteigenschaft zwischen der Schutzschicht 17 und der Bondoberfläche 7b, sodass bei einer Entfernung der Folie 15 in einem späteren Prozessschritt eine möglichst kontaminationsfreie Bondoberfläche 7b zurückbleibt.

Die **Figur 2b** zeigt einen zweiten Prozessschritt des zweiten Prozesses, bei dem ein Substrat 11'' als Temporärträger präpariert wird. Auf das Substrat 11'' wird ein Adhäsiv 18 durch eine bekanntes Verfahren, insbesondere durch einen Schleuderbelackungsprozess, aufgebracht.

Die **Figur 2c** zeigt einen dritten Prozessschritt des zweiten Prozesses, bei dem eine Kontaktierung von Rückseitenoberflächen 7r der Chips 7 mit dem Bondingadhäsiv erfolgt. Der Kontaktierung geht insbesondere eine Ausrichtung aller zueinander fixierten Chips 7 in Bezug zum Substrat 11' voraus. Denkbar ist in diesem Prozessschritt auch, dass von der Folienrückseite 15r eine mechanische Druckbeaufschlagung erfolgt, welche für die Koinzidenz der Bondoberflächen 7b aller Chips 7 in einer Ebene E sorgen soll. Die Ebene E ist dabei jene Ebene, in der sich alle Bondoberflächen 7b der Chips 7 befinden sollen. Insbesondere sollte die Ebene E identisch sein mit der Oberfläche der Schutzschicht 17, die in Richtung der Chips 7 liegt. Das ist vor allem dann von Relevanz, wenn es sich beim Träger 15 um eine Folie handelt. Denkbar ist beispielsweise, dass eine Rolle über die Folienrückseite 15r rollt. Vorzugsweise erfolgt allerdings eine vollflächige Beaufschlagung, welche eine homogene Druckverteilung zur Folge hat.

Die **Figur 2d** zeigt einen vierten Prozessschritt des zweiten Prozesses, bei dem die Folie 15 von den Bondoberflächen 7b der Chips 7 entfernt wurde. Vorzugsweise wird die Folie 15 abgezogen. Anhand der Vergrößerung Z1 erkennt man, dass ein Rest der Schutzschicht 17 nach der Entfernung der Folie 15 auf den Bondoberflächen 7b zurückbleiben kann. In diesem, weniger bevorzugten Fall, muss in einem weiteren Prozessschritt eine erneute Reinigung der Chips durchgeführt werden. Vorzugsweise sind die Bondoberflächen 7b nach der Entfernung der Folie 15 kontaminationsfrei. Die Vergrößerung Z2 zeigt eine übertriebene Darstellung zweier nebeneinanderliegenden Chips, die sich in Ihren Dicken d1 und d2 unterscheiden. Die Nachgiebigkeit des Adhäsivs 18 sorgt allerdings dafür, dass die Bondoberflächen 7b in derselben Ebene E liegen, was einen wichtigen Aspekt des Prozesses darstellt.

Die **Figur 2e** zeigt einen, optionalen, weniger bevorzugten fünften Prozessschritt des zweiten Prozesses, bei dem die Bondoberflächen 7b der Chips 7 durch ein Reinigungsverfahren gereinigt wurden. Die Vergrößerung Z1 lässt keine Schutzschicht 17 mehr erkennen.

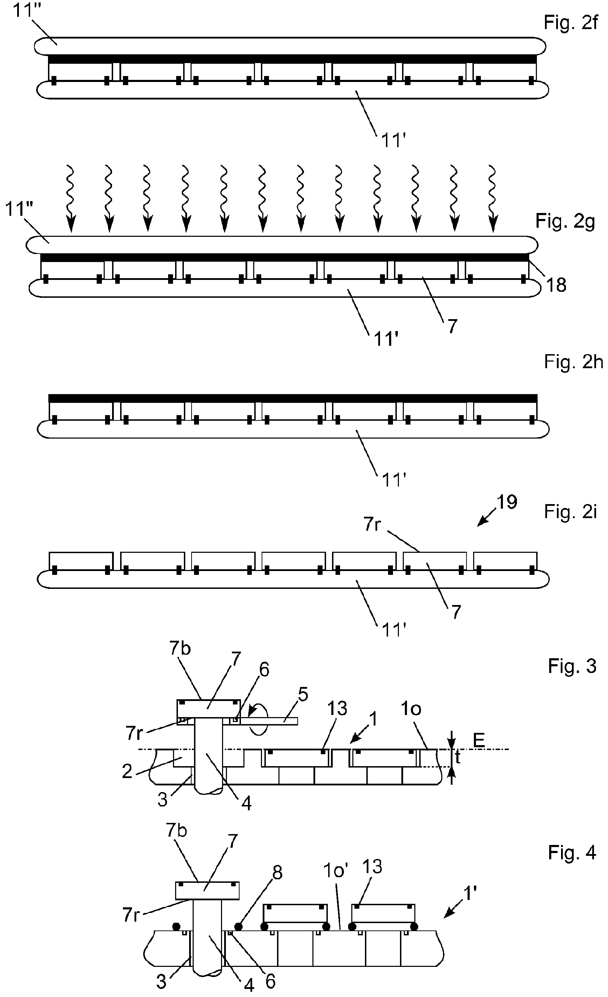

Die **Figur 2f** zeigt einen sechsten Prozessschritt des zweiten Prozesses, bei dem der mit den Chips 7 bestückte Temporärträger 11" relativ zu einem weiteren Substrat 11' ausgerichtet und gebondet wird. Es erfolgt das Bonden aller Chips 7 simultan.

Die **Figur 2g** zeigt einen siebten Prozessschritt des zweiten Prozesses, bei dem das Adhäsiv 18 behandelt wird. Die Behandlung kann chemisch und/oder thermisch und/oder mittels EM Wellen, insbesondere mittels UV-Licht oder Infrarot, erfolgen. In einer ganz besonders bevorzugten Ausführungsform erfolgt die Behandlung durch den Temporärträger 11". Die Behandlung hat vorzugsweise zur Folge, dass die Adhäsionseigenschaften des Adhäsivs 18 vermindert oder sogar gänzlich aufgehoben werden, sodass eine Loslösung des Temporärträgers 11'' von den Chips 7 erfolgen kann.

Die **Figur 2h** zeigt einen achten Prozessschritt des zweiten Prozesses, bei dem das Trägersubstrat 11" entfernt wird.

Die **Figur 2i** zeigt einen neunten Prozessschritt eines zweiten Prozesses, bei dem die Rückseitenoberflächen 7r der Chips 7 gereinigt werden. Das Ergebnis ist erneut ein Endprodukt 19.

Die **Figur 3** zeigt eine erste Ausführungsform zur Massenreinigung und/oder Plasmaaktivierung und/oder Bonden von Chips 7. Die Chips 7 befinden sich in einer Ejektorvorrichtung 1, die über Vertiefungen 2 verfügt. Am Boden der Vertiefungen 2 sind Durchführungen 3, insbesondere einfache Bohrungen, angebracht, durch welche eine Hebevorrichtung 4 einen Chip 7 heben und senken kann. Das Beladen und/oder Entladen der Chips 7 kann über einen Greifkopf 5 erfolgen, der einen Chip 7 ausschließlich an seiner Rückseitenfläche 7r mithilfe einer Fixierung 6 fixieren kann, um ihn zu transportieren. Vorzugsweise koinzidieren die Bondoberflächen 7b aller Chips 7 während einer Massenreinigung und/oder Plasmaaktivierung alle innerhalb der Ebene E. Die Koinzidenz aller Bondoberflächen 7b hat den Vorteil der homogenen Behandlung. Insbesondere bei einer Plasmabehandlung wird dadurch sichergestellt, dass die Plasmadichte homogen über die gesamte Fläche ist. Sollten sich die Chips 7 leicht in Ihren Dicken unterscheiden, so können die Hebevorrichtungen eine leichte Korrektur vornehmen um die Koinzidenz der Bondoberflächen 7b erneut sicherzustellen.

Die **Figur 4** zeigt eine zweite Ausführungsform zur Massenreinigung und/oder Plasmaaktivierung und/oder Bonden von Chips 7.

Die Chips 7 befinden sich in einer Ejektorvorrichtung 1', die über Dichtungen 8 verfügt. Die Chips 7 können mit einer Hebevorrichtung 4, welche sich durch Durchführungen 3 translatorisch bewegen kann, geladen und/oder entladen werden. Die Fixierung erfolgt vorzugsweise durch Fixierungen 6, insbesondere durch Vakuumkanäle, die bei Kontakt des Chips 7 mit der Dichtung 8 die Erzeugung eines Vakuums im Zwischenraum gestatten. Der Greifkopf 5 wurde in dieser Zeichnung der Übersichtlichkeit halber nicht eingezeichnet.

Die Ejektorvorrichtungen 1,1' dienen daher der allgemeinen Massenreinigung und/oder Plasmaaktivierung und/oder Bonden von vereinzelten Chips 7. Des Weiteren ist denkbar, dass die Ejektorvorrichtungen 1, 1' selbst so kompakt konstruiert sind, dass sie als Trägerwafer 11'' im Sinne des zweiten Prozesses verwendet werden können. In diesem Fall müssen die Bondoberflächen 7b der Chips 7 zumindest vor dem Bondprozess zum Substrat 11 leicht über die Ejektoroberflächen 1o, 1o' ragen, was für die Ejektoroberfläche 1o' des Ejektors 1' konstruktionstechnisch automatisch erfüllt ist. Insbesondere die Ejektorvorrichtung 1' eignet sich damit als eine Art Fixierträger. Bei den Fixierungen 6 kann es sich dann auch um elektrostatischen, magnetische oder Gelpak Fixierungen handeln.

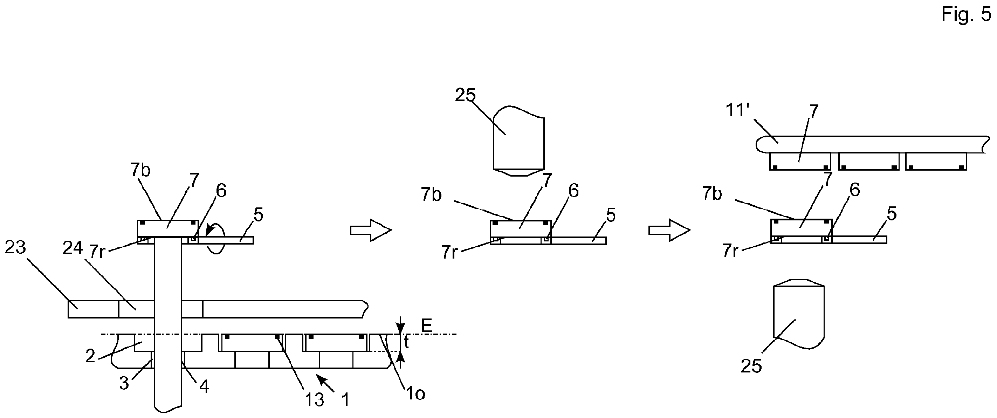

Die Figur 5 zeigt eine erste Erweiterung einer Ausführungsform des Bondens, bei dem, exemplarisch, die Ejektorvorrichtung 1 verwendet werden kann, um einen Chip 7 durch eine Apertur 24 einer Maske 23, von einem Greifkopf 5 aufnehmen zu lassen. Der aufgenommene Chip 7 wird, insbesondere über mehrere Stationen hinweg transportiert. Dabei können Optiken 25 die Bondoberflächen 7b und/oder die Rückseitenflächen 7r der Chips 7 und/oder das Substrat 11' vermessen. Insbesondere kann nach Ausrichtungsmarken (nicht eingezeichnet) auf den Chips 7 und/oder dem Substrat 11' gesucht werden, um den transportierten Chip 7 korrekt zu positionieren. In dieser Erweiterung liegt daher das zu bestückende Substrat 11' nicht direkt über den Chips.

Die **Figur 6** zeigt eine zweite Erweiterung einer Ausführungsform des Bondens, bei dem, exemplarisch, die Ejektorvorrichtung 1' verwendet werden kann, um einen Chip 7 durch eine Apertur 24 einer Maske 23, mit einem Chip 7 eines Substrats 11' zu bonden. Der Gedanke besteht darin, dass die Maske 23, die insbesondere aus einem hochreinen Werkstoff besteht, der vorzugsweise über keine Oberflächenkontamination verfügt, die Chips 7 auf der, exemplarisch verwendeten, Ejektorvorrichtung 1' vor Kontamination schützt. Damit wird erneut gezeigt, wie die Bondoberfläche 7b der Chips 7 vor Kontamination geschützt werden kann. Anstatt der, exemplarisch verwendeten, Ejektorvorrichtung 1' kann natürlich jede andere Art von Vorrichtung verwendet werden, um den Chip 7 durch die Apertur 24 zu führen und mit der, auf der anderen Seite der Maske 23 liegenden, Oberfläche eines anderen Chips 7 oder eines Substrats 11' zu bonden.

Die **Figur 7a** zeigt einen ersten Prozessschritt einer Selbstausrichtung eines Chips 7 auf einem Substrat 1'. Der Chip 7 wird durch einen Bondkopf 9 auf einem Flüssigkeitsfilm 21 abgelegt. In einer besonderen Ausführungsform ist der Flüssigkeitsfilm 21 nicht kontinuierlich über das gesamten Substrat 1' verteilt, sondern liegt lediglich als Tropfen oder Pfütze an den Stellen vor, an denen die Selbstausrichtung von Chips 7 erfolgen soll.

Erkennbar ist eine nicht optimale Ausrichtung der Kontakte 13 des Chips 7 mit den Kontakten 13 des Substrats 1'.

Die **Figur 7b** zeigt einen zweiten Prozessschritt der Selbstausrichtung des Chips 7 auf dem Substrat 1'. Der Bondkopf 9 löst die Fixierung zum Chip 7. Dieser richtet sich nun durch seine laterale Beweglichkeit aufgrund des Vorhandenseins des Flüssigkeitsfilms 21 so aus, dass die Kontaktierungen 13 des Chips 7 bestmöglich deckungsgleich mit den Kontaktierungen 13 des Substrats 1' sind. Der Grund hierfür liegt in den unterschiedlichen Bindungseigenschaften der dielektrischen und elektrischen Bereiche. Jene Bereiche die hydrophil sind, ziehen vorzugsweise hydrophile Bereiche an. Diese Wechselwirkung kann sich vorzugsweise durch Medien mit zumindest teilweise polarem Charakter ausbreiten. Wasser ist ein Dipol und eignet sich daher für diese Aufgabe besonders gut.

Die **Figur 8a** zeigt den erfindungsgemäßen Bondkopf 9, bestehend aus einer Fixierfläche 22 mit Fixierungen 6. Hinter der Fixierfläche 22 befinden sich Federelemente 10, 10' mit unterschiedlichen Federkonstanten. Vorzugsweise ist die Federkonstante des zentrisch verbauten Federelements 10 größer als die Federkonstanten der peripher verbauten Federelemente 10'. Eine Beschleunigung des Bondkopfs 9 in lateraler Richtung, hat keine Auswirkung auf die Form der Fixierfläche 22.

Die **Figur 8b** zeigt den erfindungsgemäßen Bondkopf 9 bei einer Beschleunigung in Normalenrichtung einer zu bondenden Oberfläche. Durch die höhere Federkonstante des mittleren Federelements 10, wirkt die Trägheit weniger stark auf den mittleren Teil der Fixierfläche 22 oder anders ausgedrückt, der mittlere Teil der Fixierfläche 22 folgt und reagiert schneller als der periphere Teil. Die Krümmung wird mit Vorteil auch durch die schnelle Annäherung an die Kontaktfläche und den vorhandenen Luftpolster erreicht. Der, durch die translatorische Bewegung erzeugte, Staudruck auf die Fixierfläche 22 würde diese bei identischen Federelementen symmetrisch nach hinten drücken. Die die peripheren Federelemente 10' allerdings eine kleinere Federkonstante besitzen als das mittlere Federelement 10, geben diese leichter nach, da sie elastischer sind. Neben der Trägheit bewirkt also auch der entstehende Staudruck eine Krümmung. Durch diese mechanische Asymmetrie wird die Fixierfläche 22 und damit der an ihr fixierte Chip 7 konvex gekrümmt und kann einen optimalen Kontaktpunkt 23 für einen Direktbond erzeugen. Damit wird ausgeschossen, dass der Chip 7 zuerst seitlich oder eben kontaktiert.

### Bezugszeichenliste

- 1,1': Ejektorvorrichtung
- 1o, 1o': Ejektoroberflächen
- 2: Vertiefung
- 3: Durchführung
- 4: Hebevorrichtung
- 5: Greifkopf
- 6: Fixierung
- 7: Chip
- 7b: Bondoberfläche
- 7r: Rückseitenfläche
- 8: Dichtung
- 9: Bondkopf
- 10, 10': Federelemente
- 11, 11',11'': Substrat
- 12: Fugen
- 13: Kontakte
- 14: Rahmen
- 15: Folie
- 15o: Folienoberfläche
- 15r: Folienrückseite
- 16: Trennvorrichtung
- 17: Schutzschicht
- 18: Adhäsiv
- 19: Endprodukt
- 20: Dielektrische Oberfläche
- 21: Flüssigkeit
- 22: Fixierfläche
- 23: Maske
- 24: Apertur
- 25: Optik
- d1,d2: Dicke
- E: Koinzidenzebene
- t: Tiefe
- Z1, Z2: Vergrößerungen

## Patentansprüche

1. Verfahren zum Bonden eines Chips (7) auf ein Halbleitersubstrat (11') oder auf einen weiteren Chip,
wobei
der Chip (7) durch einen Direktbond auf das Halbleitersubstrat (11') oder den weiteren Chip gebondet wird, wobei ein Bondkopf (9) den Chip (7) derart auf das Halbleitersubstrat (11') oder den weiteren Chip bondet, dass der Chip (7) zuerst im Zentrum und dann nach außen hin gebondet wird, wobei das Direktbonden an Bondoberflächen (7b) des Chips (7) erfolgt, **dadurch gekennzeichnet, dass** die Bondoberflächen (7b) Hybridbondoberflächen sind, wobei die Hybridbondoberflächen aus metallischen und dielektrischen Bereichen bestehen,
wobei der Bondkopf (9) aus einer Fixierfläche (22) mit Fixierungen (6) zur Fixierung des Chips (7) besteht,
wobei sich entweder
i) ein erstes zentrisch gelegenes Federelement (10') und peripher verbaute Federelemente (10) hinter der Fixierfläche (22) befinden, wobei die Federkonstante der peripher verbauten Federelemente (10) kleiner als die Federkonstante des ersten Federelements (10') ist,
oder
ein erstes zentrisch gelegenes Federelement (10') hinter der Fixierfläche (22) befindet und peripher auf Federelemente verzichtet wird,
und
ii) die Beschleunigung des Bondkopfs (9) in eine Richtung normal zur Bondoberfläche derart hoch ist, dass die Fixierfläche sowie der Chip (7) nur aufgrund der Massenträgheit konvex gekrümmt werden.

2. Vorrichtung zum Bonden von Chips (7) auf ein Halbleitersubstrat (11') oder weitere Chips,
wobei
die Chips (7) durch einen Direktbond auf das Halbleitersubstrat (11') oder die weiteren Chips gebondet werden können, wobei die Vorrichtung einen Bondkopf (9) aufweist, der derart ausgebildet ist, dass ein Chip (7) zuerst im Zentrum und dann nach außen hin gebondet werden kann, wobei der Direktbond an Bondoberflächen (7b) des Chips (7) erfolgt, **dadurch gekennzeichnet, dass** die Bondoberflächen (7b) Hybridbondoberflächen sind, wobei die Hybridbondoberflächen aus metallischen und dielektrischen Bereichen bestehen,
wobei der Bondkopf (9) aus einer Fixierfläche (22) mit Fixierungen (6) zur Fixierung des Chips (7) besteht,
wobei sich entweder
i) ein erstes zentrisch gelegenes Federelement (10') und peripher verbaute Federelemente (10) hinter der Fixierfläche (22) befinden, wobei die Federkonstante der peripher verbauten Federelemente (10) kleiner als die Federkonstante des ersten Federelements (10') ist,
oder
ein erstes zentrisch gelegenes Federelement (10') hinter der Fixierfläche (22) befindet und peripher auf Federelemente verzichtet wird,
und
ii) der Bondkopf (9) so ausgelegt ist, dass er in eine Richtung normal zur Bondoberfläche derart hoch beschleunigen kann, dass die Fixierfläche sowie der Chip nur aufgrund der Massenträgheit konvex gekrümmt werden können.

## Claims

1. A method for bonding a chip (7) on a semiconductor substrate (11') or on a further chip,
wherein
the chip (7) is bonded by a direct bond on the semiconductor substrate (11') or the further chip,
wherein a bonding head (9) bonds the chip (7) on the semiconductor substrate (11') or the further chip in such a way that the chip (7) is bonded first in the centre and then outwards, wherein the direct bonding takes place at the bonding surfaces (7b) of the chip (7),
**characterised in that** bonding surfaces (7b) are hybrid bonding surfaces, wherein the hybrid bonding surfaces consist of metallic or dielectric regions,
wherein the bonding head (9) consists of a fixing surface (22) with fixings (6) for fixing the chip (7),
wherein either
i) a first concentrically located spring element (10') and peripherally installed spring elements (10) are positioned behind the fixing surface (22), wherein the spring constant of the peripherally installed spring elements (10) is less than the spring constant of the first spring element (10'),
or
a first concentrically located spring element (10') is located behind the fixing surface (22) and spring elements are omitted at the periphery,
and
ii) the acceleration of the bonding head (9) is so high in a direction
normal to the bonding surface that the fixing surface and the chip (7) are curved only by reason of the mass inertia.

2. A device for bonding chips ((7) on a semiconductor substrate (11') or further chips,
wherein
the chips (7) can be bonded by a direct bond on the semiconductor substrate (11') or the further chips,
wherein the device comprises a bonding head (9), which is designed in such a way that a chip (7) is bonded first in the centre and then outwards, wherein the direct bonding takes place at the bonding surfaces (7b) of the chip (7), **characterised in that** bonding surfaces (7b) are hybrid bonding surfaces, wherein the hybrid bonding surfaces consist of metallic or dielectric regions,
wherein the bonding head (9) consists of a fixing surface (22) with fixings (6) for fixing the chip (7),
wherein either
i) a first concentrically located spring element (10') and peripherally installed spring elements (10) are positioned behind the fixing surface (22), wherein the spring constant of the peripherally installed spring elements (10) is less than the spring constant of the first spring element (10'),
or
a first concentrically located spring element (10') is located behind the fixing surface (22) and spring elements are omitted at the periphery,
and
ii) the bonding head (9) is designed in such a way that it can accelerate so highly in a direction normal to the bonding surface that the fixing surface and the chip can be curved in a convex manner solely by reason of the mass inertia.

## Revendications

1. Procédé d'assemblage d'une puce (7) sur un substrat semi-conducteur (IP) ou sur une autre puce,
la puce (7) étant assemblée par un assemblage direct sur le substrat semi-conducteur (11') ou la puce suivante,
une tête d'assemblage (9) assemblant la puce (7) sur le substrat semi-conducteur (11') ou sur la puce supplémentaire de telle sorte que la puce (7) soit d'abord assemblée au centre, puis vers l'extérieur, l'assemblage direct étant effectué sur des surfaces d'assemblage (7b) de la puce (7),
**caractérisé en ce que** les surfaces d'assemblage (7b) sont des surfaces d'assemblage hybrides, les surfaces d'assemblage hybrides étant constituées de zones métalliques et diélectriques,
la tête d'assemblage (9) étant composée d'une surface de fixation (22) avec des fixations (6) pour fixer la puce (7),
soit
i) un premier élément à ressort centralisé (10') et des éléments de ressort montés de manière périphérique (10) se trouvant derrière la surface de fixation (22), la constante de ressort des éléments à ressort montés de manière périphérique (10) étant inférieure à la constante de ressort du premier élément à ressort (10'),
soit
un premier élément à ressort centralisé (10') se trouve derrière la surface de fixation (22) et périphérique est renoncé aux éléments de ressort,
et
ii) l'accélération de la tête d'assemblage (9) dans un sens normal à la surface d'assemblage étant si élevée que la surface de fixation et la puce (7) ne prennent une courbure convexe que par inertie de masse.

2. Dispositif pour l'assemblage de puces (7) sur un substrat semi-conducteur (11') ou d'autres puces, dans lequel
les puces (7) peuvent être assemblées au substrat semi-conducteur (11') ou aux autres puces par assemblage direct,
le dispositif ayant une tête d'assemblage (9) formée de telle manière qu'une puce (7) puisse d'abord être assemblée au centre, puis vers l'extérieur, l'assemblage direct étant effectué sur des surfaces d'assemblage (7b) de la puce (7), **caractérisé en ce que** les surfaces d'assemblage (7b) sont des surfaces d'assemblage hybrides, les surfaces d'assemblage hybrides étant composées de zones métalliques et diélectriques,
la tête d'assemblage (9) est constituée d'une surface de fixation (22) avec des fixations (6) pour fixer la puce (7), soit
i) un premier élément à ressort centralisé (10') et des éléments à ressort montés de manière périphérique (10) se trouvant derrière la surface de fixation (22), la constante de ressort des éléments à ressort montés de manière périphérique (10) étant inférieure à la constante de ressort du premier élément de ressort (10'),
soit
un premier élément à ressort centralisé (10') se trouvant derrière la surface de fixation (22) et sachant qu'on ne prévoit pas d'éléments à ressort en périphérie,
et
ii) la tête d'assemblage (9) étant conçue de telle sorte qu'elle puisse accélérer normalement dans une direction par rapport à la surface d'assemblage à une vitesse telle que la surface de fixation et la puce puissent prendre une courbure convexe que par inertie de masse.
